# EUROPEAN PATENT SPECIFICATION

(11) **EP 3 410 056 B1**
(45) Date of publication and mention of the grant of the patent: **24.03.2021**
(21) Application number: 17744469.2
(22) Date of filing: 26.01.2017
(51) Int. Cl.: F28F 3/08, B21D 53/04, F28D 1/03, H05K 1/02, H05K 7/20, F28D 21/00

(54) **STACKED PLATE HEAT EXCHANGER**
GESTAPELTER PLATTENWÄRMETAUSCHER
ÉCHANGEUR DE CHALEUR À PLAQUES EMPILÉES

(30) Priority: 27.01.2016 JP 2016012910
(43) Date of publication of application: 05.12.2018
(73) Proprietor: T.RAD Co., Ltd., Shibuya-ku Tokyo 151-0053 (JP)
(72) Inventor: BUNGO, Takuya, Tokyo 151-0053 (JP); OKUBO, Atsushi, Tokyo 151-0053 (JP); SAKAI, Taiji, Tokyo 151-0053 (JP)
(74) Representative: Mewburn Ellis LLP
(86) International application number: PCT/JP2017/003878
(87) International publication number: WO 2017/131240

(56) References cited:
- DE-A1-102009 006 855
- DE-A1-102013 014 434
- JP-A- H08 233 481
- JP-A- 2006 292 223
- JP-A- 2007 017 054
- JP-A- 2007 017 054
- SE-L- 0 500 567
- US-A- 5 587 053

## Description

### Technical Field

The present invention relates to a stacked plate heat exchanger applicable for a cooler and the like to cool electronic devices such as an inverter.

### Background Art

Heretofore, as a stacked plate heat exchanger (solid cooler) applicable for a cooler for electronic devices such as an inverter and the like, there are known a cup plate structure in which inner plates having a flow path are stacked and surrounded with a top plate in a flat plate shape and a bottom plate in a cup shape, as well as a completely stacked structure in which they are sandwiched with a top plate and a bottom plate both having a flat plate shape.

With respect to these stacked plate heat exchangers, generally the whole of a heat exchanger is integrally brazed and manufactured, but, in brazing, inner plates, a cup plate and the like are necessarily stacked and temporarily fixed in a positioned state. As methods of temporary fixing, a method of welding an outer peripheral part of a stacked body, and a method of using a special fixing jig are known. However, welding of an outer peripheral part causes such problems that the manufacturing process becomes considerably complex and welding marks remain also in a finished product, and in the case of using a special fixing jig, there is such a problem as increase in cost by that.

In Patent Literature 1, a manufacturing method of a stacked plate heat exchanger is disclosed. In the method in Patent Literature 1, a plurality of plates, in which a hole other than a coolant flow path is separately formed, are stacked and a pipe for temporary fixing, for example, a pipe such as a grooved spring pin is inserted into the hole to temporarily fix the respective plates to one another, and brazing or the like is performed in the state.

DE102013014434A1 discloses a brazed plate heat exchanger according to the preamble of claim 1, having a stack of heat exchanger plates with a peripheral contour formed from edges of the heat exchanger plates, and a base plate that projects beyond the peripheral contour in the manner of a projection. The brazed plate heat exchanger further has a support which is arranged at a point on the projection of the base plate and that is connected to the peripheral contour of the stack of heat exchanger plates, wherein the support extends in height over a plurality of the edges of the stacked heat exchanger plates.

JP2007017054A discloses a plate-like heat exchanger, wherein on a first side plate including guide pieces raised substantially at a right angle from the outer periphery, plate-like elements having fluid passages and an isolation plate as a heat exchange membrane are superposed along the guide pieces so that guide projections provided on the elements and the isolation plate are fitted to the guide pieces, and a second side plate is finally placed thereon. The first side plate, the plate-like elements, the isolation plate and the second plate-like element 20 are heated at high temperature with pressure and diffusion-bonded.

### Citation List

### Patent Literature

PTL 1: Japanese Patent No. 3026315

### Summary of Invention

### Technical Problem

In the method in Patent Literature 1, an expensive part such as a grooved spring pin is necessary and the number of parts becomes large because such a part and the plate are parts of mutually separated bodies. Accordingly, there are such problems that manufacturing cost rises in accordance with those problems and manufacturing operability also deteriorates.

### Solution to Problem

According to the present invention there is provided a stacked-plate heat exchanger as specified in claim 1.

The stacked plate heat exchanger according to the present invention may optionally be as specified in any of of claims 2 to 4.

### Advantageous Effects of Invention

The present invention is configured such that an upwardly bent tab part is formed on at least one of plates, a cutout part is formed in plates other than the plate on which the tab part is formed, and the plates are stacked and fixed to one another with the tab part and the cutout part in a fitted state.

The stacked plate heat exchanger configured as described above has a simple structure that suppresses complexity of structure and increase in cost. In the manufacturing process thereof, the use of expensive parts is unnecessary, and it becomes possible to temporarily fix plates simply with low cost by a method in which the increase in the number of parts is suppressed.

The present invention is configured such that the tab part has a rectangular shape with a pair of side surfaces and an end part, the cutout part has a rectangular shape with a pair of side surfaces and a bottom surface, both side surfaces of the tab part abut on both side surfaces of the cutout part, respectively, and the surface of the tab part in the bent direction is separated from the bottom surface of the cutout part.

As a result of the configuration, in manufacturing, even in the cases where the upwardly bent part of the tab part, that is, a bent edge part of the tab part is slightly curved or a certain variation is generated in upwardly bent angles due to a manufacturing error or the like, the plate is prevented from running on the edge part portion in the fitting. Then, the tab part does not interfere with the bottom surface of the cutout part and consequently temporary fixing can be performed more surely and accurately. As a result, a more accurate heat exchanger can be obtained.

The present invention may be configured such that the cutout part is formed in a periphery edge part of the plate. As a result of the configuration, in the manufacturing process, it becomes possible to upwardly bend the tab part and then plates are stacked and temporarily fixed, or to stack plates and then the tab part is upwardly bent to thereby perform temporary fixing. As a result, a degree of freedom in temporary fixing work increases and the optimum temporary fixing work becomes possible in accordance with a plate configuration and/or manufacturing process.

The present invention may be configured such that a plate on which the tab part has been formed is arranged to an intermediate layer excluding the uppermost layer and lowermost layer in a plurality of the inner plates. As a result of the configuration, in manufacturing, plates having different cutout positions each other may be arranged on an upper and lower side of the intermediate layer. Consequently, two types of inner plates having different flow path specifications may be combined on the upper and lower sides of the intermediate layer, without erroneous arrangement, to be temporarily fixed.

The present invention may be configured such that the tab part is formed on at least one of the top plate and bottom plate. As a result of the configuration, in manufacturing, the entire core of a heat exchanger, not only the inner plates, may be integrally and temporarily fixed.

### Brief Description of Drawings

Fig. 1 illustrates an exploded perspective view of respective members in temporary fixing of a stacked plate heat exchanger of the present invention according to a first embodiment.
Fig. 2 illustrates a perspective view showing a state where the stacked plate heat exchanger of Fig. 1 is temporarily fixed.
Fig. 3 illustrates an exploded perspective view of respective members in temporary fixing of the stacked plate heat exchanger of the present invention according to a second embodiment.
Fig. 4 illustrates a perspective view showing a state where the stacked plate heat exchanger of Fig. 3 is temporarily fixed.
Fig. 5 illustrates a perspective view showing a tab part and a cutout part formed on/in a periphery edge part of an inner plate in the stacked plate heat exchanger shown in Fig. 3.
Fig. 6 illustrates a perspective view showing a fitting process of the tab part and cutout part shown in a VI part in Fig. 5.
Fig. 7 illustrates (A) an exploded perspective view of respective inner plates in temporary fixing, and (B) a perspective view of inner plates after the temporary fixing, in a third embodiment of the stacked plate heat exchanger of the present invention.
Fig. 8 illustrates (A) an exploded perspective view of respective inner plates in temporary fixing, and (B) an enlarged perspective view showing the B part in (A), in a fourth embodiment of the stacked plate heat exchanger of the present invention.
Fig. 9 illustrates (A) an exploded perspective view of respective inner plates, (B) an enlarged perspective view showing the B part in (A), and (C) a partially enlarged cross-sectional view seen along the C-C arrow in (B), in temporary fixing in a fifth embodiment of the stacked plate heat exchanger of the present invention.

### Description of Embodiments

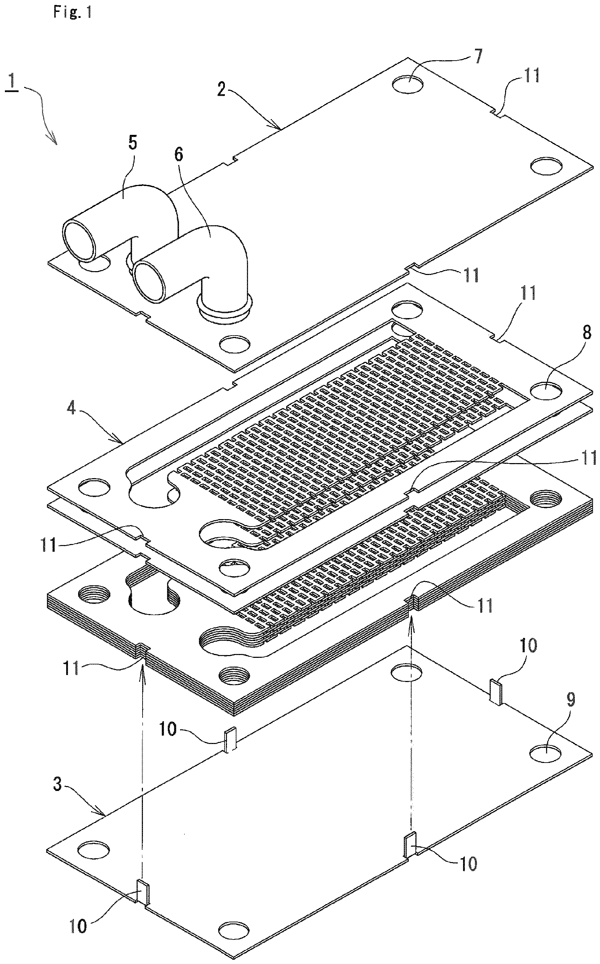

Fig. 1 illustrates a first embodiment of a stacked plate heat exchanger, and shows respective members when temporary fixing is performed as an exploded perspective view. A heat exchanger 1 has a completely stacked structure, and includes a top plate 2, a bottom plate 3 and a plurality of inner plates 4 to be a heat exchange part.

Material of respective plates is a metal such as aluminum (including alloys) and stainless steel, which may be a natural material or a cladding material in which a surface of mother material is covered with a brazing material. Incidentally, in the case of a natural material, it is used by applying a brazing material to a portion to be joined.

The planar shape of respective plates is formed as a rectangular shape (specifically rectangle). The top plate 2 has a fluid inlet pipe 5 and a fluid outlet pipe 6 for cooling water or the like, and is provided with a bolt hole 7 at four corners thereof for fixing the heat exchanger 1, to an object to be fixed, for example. At four corners of respective inner plates 4 and the bottom plate 3, too, bolt holes 8 and 9 are provided so as to coincide with the bolt hole 7.

At the center part of each of four periphery edge parts of the bottom plate 3, a tab part 10 is respectively formed. When the bottom plate 3 is molded, the tab parts 10 in a rectangle projecting in the surface direction are formed integrally at positions where respective tab parts 10 are to be formed. By upwardly bending the projecting part in 90 degrees, the tab part 10 having an angle as illustrated in the drawing is formed. The height of the tab part 10 in this embodiment coincides with the total thickness of the bottom plate 3, a plurality of the inner plates 4 and the top plate 2.

In four periphery edge parts in the top plate 2 and respective inner plates 4, cutout parts 11 having rectangular planar shapes are formed. Positions of the respective cutout parts 11 match positions of the respective tab parts 10 formed on the bottom plate 3 as shown by respective arrows.

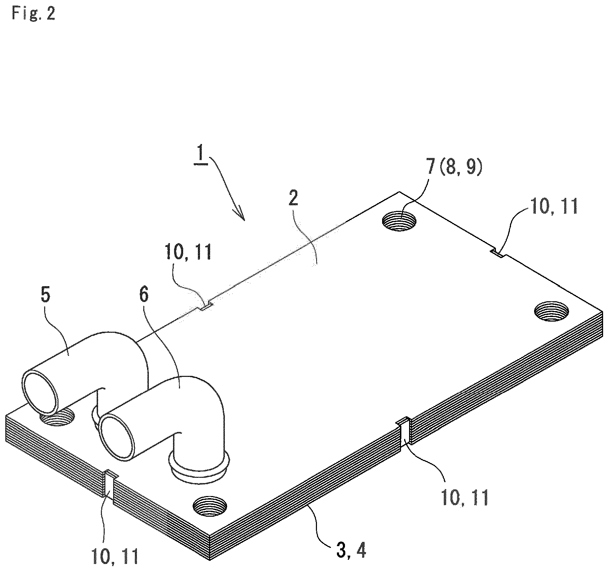

Fig. 2 illustrates a perspective view showing a state where a stacked plate heat exchanger in Fig. 1 is temporarily fixed. The top plate 2, the bottom plate 3 and a plurality of the inner plates 4 are stacked in close contact with each other, and respective tab parts 10 formed on the bottom plate are fitted to cutout parts 11 formed in the top plate 2 and respective inner plates 4.

In order to stack and temporarily fix these from a decomposed state in Fig. 1 to a state in Fig. 2, each cutout part 11 of respective inner plates 4 is made to coincide with each tab part 10 of the bottom plate 3, and in the state, while each tab part 10 is fitted to each cutout part 11 corresponding thereto, these are stacked. Subsequently, onto the upper surface of the stacked inner plates 4, the top plate 2 is stacked. On this occasion, in the same way as the inner plate 4, the stacking is performed, fitting each of tab parts 10 to each of cutout parts 11 each other.

As an alternative method, a plurality of inner plates 4 are stacked in advance, the top plate 2 is arranged to the stacked body and then a bottom plate is arranged to the bottom surface of the stacked body, and respective tab parts 10 are upwardly bent to perform the fitting at once. Moreover, by increasing the length of the tab part 10 formed on the bottom plate 3 up to reach the top plate 2, the top plate 2, the inner plate 4 and the bottom plate can also be temporarily fixed all together.

Each plate stacked as described above can be stacked with high accuracy and easily on the basis of a positioning effect caused by the fitting of the tab part 10 and the cutout part 11. Then, the temporarily fixed stacked body as illustrated in Fig. 2 is mutually fixed by brazing or the like.

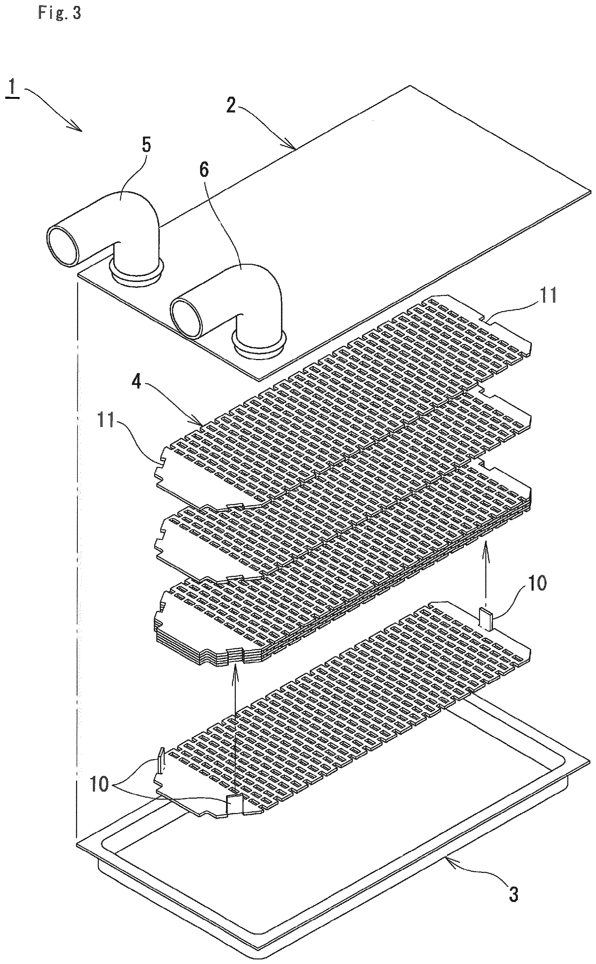

Fig. 3 illustrates a second embodiment of the stacked plate heat exchanger, in which respective members when temporary fixing is performed are shown as an exploded perspective view. The heat exchanger 1 has a cup plate structure. A different point of a heat exchanger 1 of this embodiment from the heat exchanger 1 of the completely stacked type in Fig. 1 is a combination form of the top plate and the cup-shaped bottom plate, and the others are configured in the same way. Accordingly, the same sign is given to the same part as that in the heat exchanger 1 in Fig. 1, and overlapping explanation will be omitted.

In Fig. 3, the bottom plate 3 configuring the heat exchanger 1 is formed in a cup type having a short side wall at a periphery edge part instead of the flat plate shape in Fig. 1. It is configured such that the top plate 2 is formed in a flat plate shape, and that the periphery edge part thereof can be mounted on a flange formed on the upper part of the short side wall of the bottom plate 3.

In this embodiment, on the periphery edge part of the inner plate 4 to be lain at the lowermost tier in stacking, three tab parts 10 are formed. In the inner plate 4, as shown in the drawing, one end part is formed in a trapezoidal shape and the other end part is formed in an approximately rectangular shape, and the tab parts 10 are formed on two slopes of the trapezoidal end part and on the center part of the rectangular end part.

In the periphery edge part of each of the other inner plates on which no tab part 10 is formed, three cutout parts 11 are formed. Positions of each cutout part 11 match, as shown according to arrows, the positions of tab parts 10. Then, by fitting each of the tab parts 10 on the inner plate 4 at the lowermost tier to each of the cutout parts 11 in the other inner plates 4, a plurality of the inner plates 4 are temporarily fixed one another.

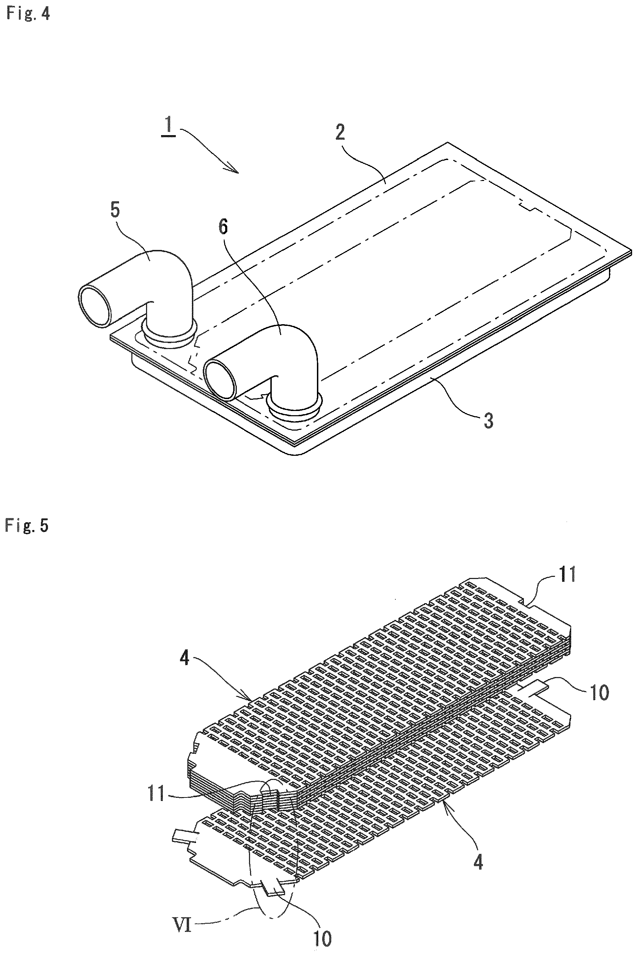

Fig. 4 illustrates a state where the inner plates 4 having been temporarily fixed one another as described above are fixed to one another by brazing or the like, subsequently the bottom plate 3 is arranged on the bottom surface side thereof, and then the periphery edge part of the top plate 2 arranged on the upper surface side is mounted on the flange at the upper part of side wall of the bottom plate 3. After the assembling into the state as illustrated in Fig. 4, respective members of the top plate 2, the inner plate 4 and the bottom plate 3 can be brazed all together and fixed.

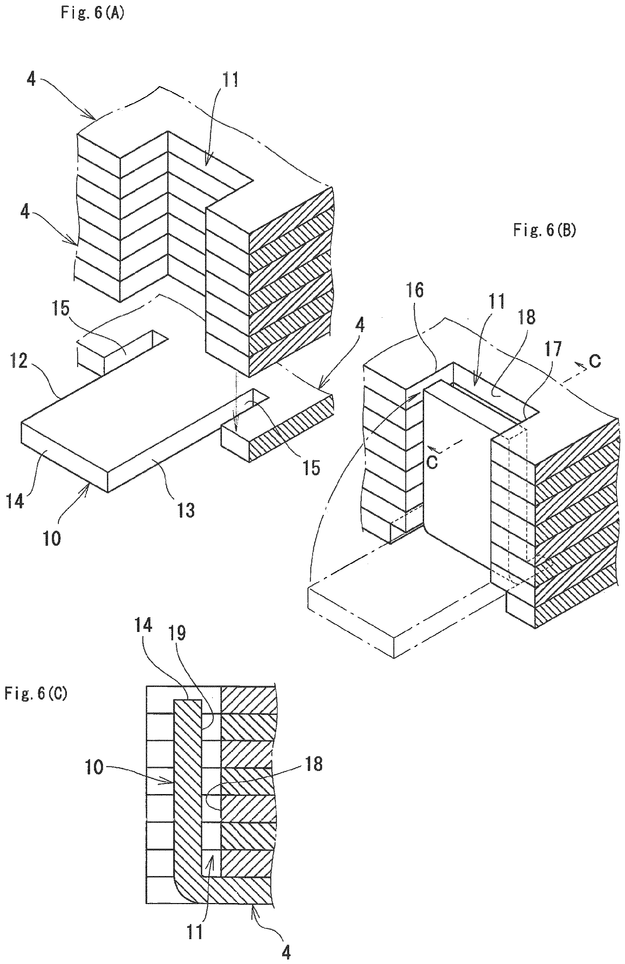

Fig. 5 illustrates only a part of inner plates shown in Fig. 3, in which a range of a sign VI shown with a dashed one-dotted line in the drawing is a part of the tab part 10 and the cutout part 11. Note that, in the example shown in Fig. 5, there is shown the tab part 10 in a state before being upwardly bent, that is, the tab part 10 in a state parallel to the surface of the inner plate. A fitting process of the tab part 10 and the cutout part 11 formed as described above is shown in Fig. 6.

Fig. 6 (A) shows the same state as Fig. 5 before the fitting, (B) shows the state after the fitting, and (C) shows a partially enlarged cross-sectional view in (B) seen in a C-C arrow direction.

As shown in Fig. 6 (A), the tab part 10 formed on a periphery edge part of the inner plate 4 lying on the lowermost tier in stacking is formed in a long and thin rectangular shape having a pair of side surfaces 12 and 13 parallel to each other and an end part 14 forming the tip of these, and, on each outside of side surfaces 12 and 13, a gap part 15 in a long and thin rectangular shape is provided.

The length in a longer direction of the tab part 10 is set to a value matching the total thickness of the other inner plates 4 on which no tab part 10 is formed. Incidentally, two gap parts 15 are provided in order to make the upward bending of the tab part 10 easy. Moreover, each bottom surface position in two gap parts 15 works as a starting point part when the tab part 10 is to be upwardly bent.

Each cutout part 11 formed in the other inner plates 4, on which no tab part 10 is formed, is formed in a rectangular shape having a pair of side surfaces 16 and 17 parallel to each other and a flat bottom surface 18 orthogonal to these side surfaces 16 and 17, as shown in Fig. 6(B), and a space between the pair of side surfaces 16 and 17 is set to a value matching the space between side surfaces 12 and 13 of the tab part 10, that is, a value that can secure and maintain suitable fitting strength.

When the inner plate 4 on which the tab part 10 is formed and a plurality of the inner plates 4 on which no tab part 10 is formed are to be stacked following an arrow in Fig. 6(A), each of periphery edge parts of all the inner plates 4 is made to coincide with each other. By upwardly bending the tab part 10 according to an arrow in Fig. 6(B) in the coincided state as described above, the tab part 10 and a plurality of cutout parts 11 are fitted at a time.

As shown in Fig. 6(C), in the state where the tab part 10 has been upwardly bent and fitted to the cutout part 11, a surface 19 of the tab part 10 in the bent direction, that is, the surface facing the bottom surface 18 of the cutout part 11 in the upwardly bent state is separated with a predetermined space from the bottom surface 18 of the cutout part. The space of the separation can be set as intended by selecting positions of flat bottom surfaces in two gap parts 15 of the tab part 10, in other words, a space between the position to be the start point part when the tab part 10 is to be upwardly bent and a position of the the bottom surface 18 of the cutout part 11.

As a consequence of setting the surface 19 of the tab part 10 in a bending direction to be separated from the bottom surface 18 of the cutout part with a predetermined space in this way, as described above, even if the bent edge part of the tab part is slightly curved or slightly varies in angle, the plate is surely prevented from running on the bent part in the fitting. Moreover, the tab part does not interfere with the bottom surface of the cutout part, the temporary fixing can be performed more surely with high accuracy.

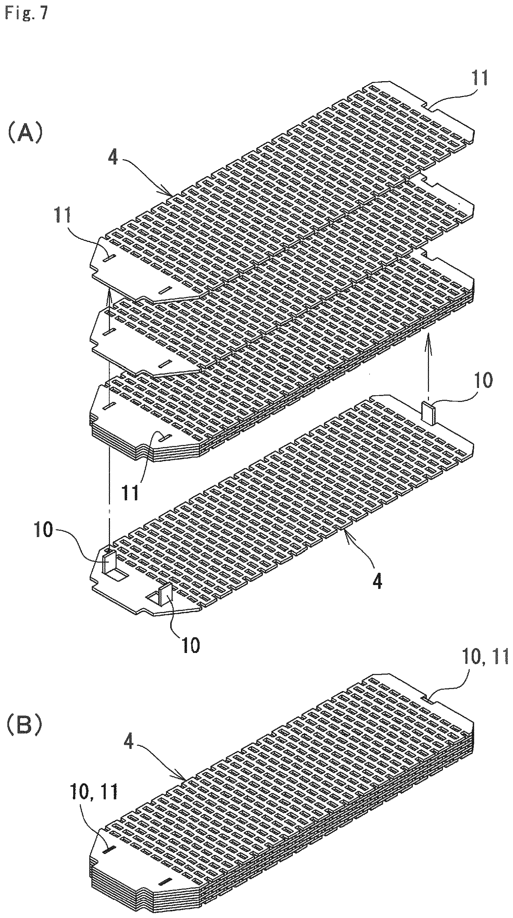

Fig. 7 illustrates a third embodiment of the stacked plate heat exchanger, in which (A) shows an exploded perspective view regarding respective inner plates in the temporary fixing, and (B) shows a perspective view of the inner plates after the temporary fixing. Different points of this embodiment from the inner plate 4 shown in Fig. 3 are only the shape of the tab part 10 and the shape of the cutout part 11 to be fitted thereto, and the others are configured in the same way.

As shown in Fig. 7 (A), in the longer direction of the inner plate 4, one of end parts thereof is formed in a trapezoidal shape and the other end part is formed in an approximately rectangular shape, and each of the tab parts 10 is formed on two portions in the inside separated from the periphery edge part of the end part of trapezoidal shape and on one portion at the periphery edge part of the end part of rectangular shape. The tab parts 10 formed on two portions in the inside separated from the periphery edge part of the end part of trapezoidal shape are upwardly bent to the outside in width direction of the inner plate 4 formed in a long and thin shape.

This tab part 10 is formed in a long and thin rectangular shape having a pair of side surfaces parallel to each other and an end part forming the front edge thereof in the same way as the tab part 10 shown in Fig. 6. Moreover, the length thereof is set, in the same way as the example in Fig. 6, to a value matching with the total thickness of the other inner plates 4 on which no tab part 10 is formed. Incidentally, the tab part 10 formed on one portion of the periphery edge part of the end part in rectangular shape has also the same shape.

The cutout parts 11 in the other inner plates 4 on which no tab part 10 is formed have different shapes in the trapezoidal end part and in the rectangular end part of these inner plates 4. That is, the cutout part 11 in the end part of trapezoidal shape is formed of a hole part in a long and thin rectangular shape. Length in the longer direction in the hole part of a rectangular shape is a value matching the space of side surfaces of the tab part 10 to be fitted thereto, in other words, is set to a value that can secure and keep a suitable fitting strength. On the other hand, the cutout part 11 in the end part of the rectangular shape is formed in the same shape as the cutout part shown in Fig. 6.

When respective inner plates 4 shown in Fig. 7(A) are stacked and the tab parts 10 and respective cutout parts 11 are mutually fitted and temporarily fixed, a state in Fig. 7(B) is given. In Fig. 7(B), at the end part of the trapezoidal shape in the inner plates 4, a pair of the tab parts 10 on the inner plate 4 lying on the lowermost tier are linearly inserted into the cutout parts 11 in respective inner plates 4 lying on the upper side stacked thereon to thereby be fitted to each other. On the other side, at the end parts of the rectangular shape in the inner plates 4, a pair of the tab parts 10 on the inner plate 4 lying at the lowermost part are upwardly bent and fitted from a lateral direction to the cutout parts 11 of respective inner plates 4 stacked on the upper side.

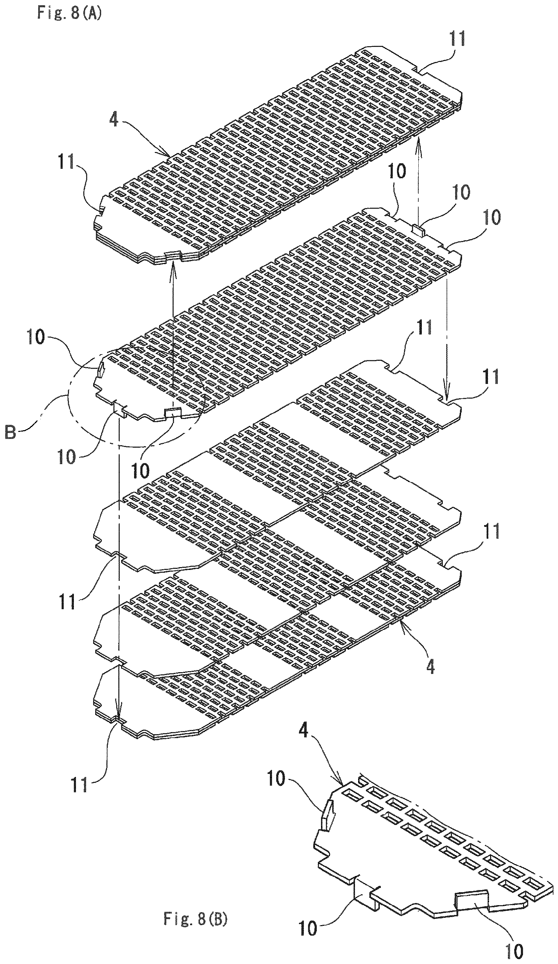

Fig. 8 illustrates a fourth embodiment of the stacked plate heat exchanger, in which Fig. 8(A) is an exploded perspective view of respective inner plates when they are temporarily fixed, and Fig. 8(B) is an enlarged perspective view of a B part shown in Fig. 8(A). Each inner plate of this embodiment has a shape similar to that of the inner plate 4 shown in Fig. 7, and one of end parts in the longer direction is formed in a trapezoidal shape and the other end part is formed in an approximately rectangular shape. However, in the embodiment, a circulation hole for a fluid to be formed in the inner plate 4 is vertically classified into two types bordering approximately the center portion of the number of stacking tiers.

That is, circulation holes of inner plates 4 on the upper side in Fig. 8(A) are aligned approximately over the entire surface of the plate, but circulation holes of inner plates 4 on the lower side are aligned with a space over the plate surface. A heat exchange performance of inner plates 4 stacked in this way is higher on the upper tier side as compared with the lower tier side. With respect to a heat exchanger based on the inner plate configuration, for example, electric parts that require a high heat exchange performance can be arranged on the outer surface (top surface) on the upper tier side, and electric parts for which a heat exchange performance may be slightly low can be arranged on the outer surface (bottom surface) on the lower tier side. Consequently, two types of cooling becomes possible with a single heat exchanger, and an overall heat exchange efficiency can also be improved.

In Fig. 8 (A), on one inner plate 4 lying at approximately the central portion of inner plates 4 to be stacked, a plurality of tab parts 10 are formed, and in the other inner plates 4, cutout parts 11 are formed. On the inner plate 4 on which tab parts 10 are to be formed, on three positions of the periphery edge part in the end part of trapezoidal shape thereof, tab parts 10 each having a rectangular shape are formed, in which, as shown in Fig. 8 (B) in an enlarged state, the tab part 10 at the center of the periphery edge part is formed downward and tab parts 10 lying on right and left sides of the periphery edge part and sandwiching the downward one are formed upward. Moreover, on three positions of the periphery edge part of the end part in rectangular shape, too, tab parts 10 each having a rectangular shape are formed, in which the tab part 10 at the center of the periphery edge part is formed upward, and tab parts 10 lying on right and left sides of the periphery edge part and sandwiching the upward one are formed downward.

Each cutout part 11 of respective inner plates 4 lying on the upper tier side, on which no tab part 10 is formed, is formed in a rectangular shape in a positon corresponding to the upward tab part 10 in the inner plate 4 on which tab parts 10 have been formed. On the other hand, each cutout part 11 in the plurality of inner plates 4 lying on the lower tier side, on which no tab part 10 is formed, is formed in a rectangular shape in a position corresponding to the position of the downward tab part 10 in the inner plate 4 on which the tab parts 10 are formed.

The inner plates 4 in a plurality of tiers configured as described above are temporarily fixed by fitting tab parts 10 formed on one inner plate 4 lying approximately the central portion to cutout parts 11 formed in the other inner plates 4 each other. When the fitting is to be performed, a process similar to the fitting process shown in Fig. 6 may be used, but, in some cases, the tab parts 10 may also be fitted in a state formed upward or downward to the cutout parts 11, as shown in Fig. 8(A).

As described above, in this embodiment, the location of the upward tab part 10 and the location of the downward tab part 10 are different from each other. The reason is that fitting locations of respective inner plates 4 lying on the upper tier side do not mutually overlap the fitting locations of respective inner plates 4 lying on the lower tier side to prevent erroneous assembling.

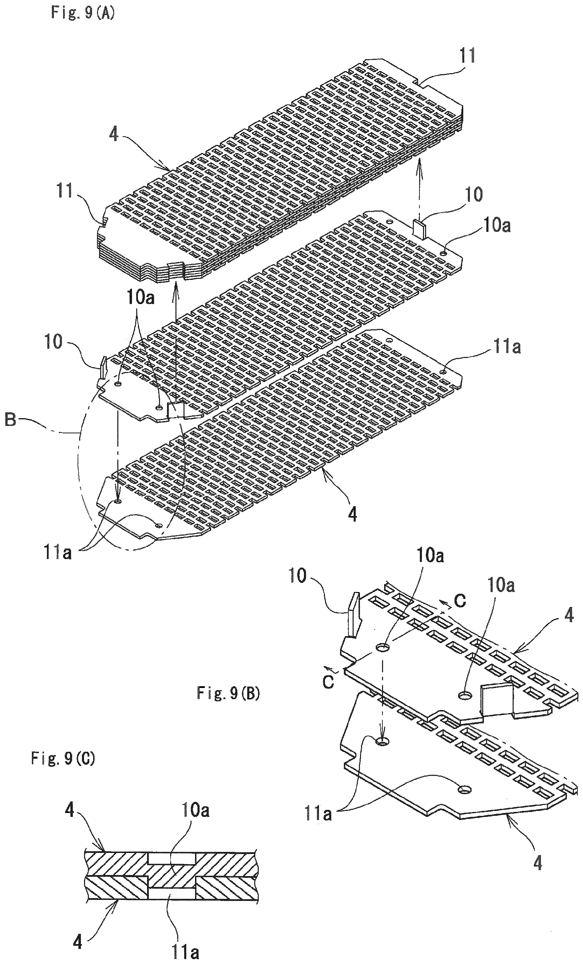

Fig. 9 relates to a fifth embodiment, in which Fig. 9(A) is an exploded perspective view of respective inner plates when the temporary fixing is performed, Fig. 9(B) is an enlarged perspective view showing a B part in Fig. 9(A), and Fig. 9(C) is a partially enlarged cross-sectional view seen from a C-C arrow direction in Fig. 9(B). An inner plate configuration of this embodiment is a modified example of the inner plate configuration shown in Fig. 8. Two different points from the embodiment in Fig. 8 are that an inner plate 4 on which the tab part 10 is to be formed is an inner plate 4 to be stacked in contact with the upper side of the lower most tier, and that a fitting structure between a part of the tab parts 10 and the cutout part 11 in the inner plate lying at the lowermost tier is different.

In the inner plate 4 on which the tab part 10 is to be formed, at three portions in a peripheral part thereof, tab parts 10 in an upward rectangular shape have been formed in the same way as that in the embodiment in Fig. 8. In addition, as shown in Fig. 9(B) in an enlarged state, a tab part 10a in a short columnar shape (so-called a half blanking dowel type) is formed at four positions.

Cutout parts 11 of respective inner plates 4 lying on the upper tier side, on which no tab part 10 is formed, are formed at positions corresponding to the upward tab parts 10, and have a rectangular shape in the same way as that in the embodiment in Fig. 8. On the other hand, a cutout part 11a in the inner plate 4 lying at the lowermost tier has been formed in a through hole having a circular cross-section with a size corresponding to the columnar shape of the tab part 10a.

Fitting between the inner plate 4 on which the tab part 10 is formed and the inner plate 4 lying on the upper tier side, in which the cutout part 11 in a rectangular shape is formed, is the same as that in the embodiment in Fig. 8. On the other hand, fitting between the inner plate 4 on which the tab part 10a in a short columnar shape is formed and the inner plate 4 lying at the lowermost tier, in which the cutout part 11a configured of a circular through hole is formed, is performed as shown in Fig. 9 (C) by inserting the tab part 10a in a columnar shape into the cutout part 11a configured of a circular through hole.

### Industrial Applicability

The stacked plate heat exchanger of the present invention is applicable for a cooler for cooling electronic devices such as an inverter, and the like.

### Reference Signs List

- 1:: heat exchanger
- 2:: top plate
- 3:: bottom plate
- 4:: inner plate
- 5:: fluid inlet pipe
- 6:: fluid outlet pipe
- 7:: bolt hole
- 8, 9:: bolt hole
- 10:: tab part
- 10a:: tab part
- 11:: cutout part
- 11a:: cutout part
- 12, 13:: side surface
- 14:: end part
- 15:: gap part
- 16, 17:: side surface
- 18:: bottom surface
- 19:: surface

## Claims

1. A stacked plate heat exchanger comprising a top plate (2), a bottom plate (3) and a plurality of inner plates (4), wherein
an upwardly bent tab part (10) is formed on at least one of the plates,
a cutout part (11) is formed in the plates other than the plate on which the tab part (10) is formed,
each plate is stacked and fixed to one another with the tab part (10) and the cutout part (11) in a fitted state,
the tab part (10) is formed in a rectangular shape with a pair of side surfaces (12, 13) and an end part (14), **characterised in that** the cutout part (11) is formed in a rectangular shape with a pair of side surfaces (16, 17) and a bottom surface (18),
both side surfaces of the tab part (10) abut on both side surfaces of the cutout part (11), respectively, and
a surface (19) of the tab part (10) in the bent direction is separated from the bottom surface (18) of the cutout part (11) .

2. The stacked plate heat exchanger according to claim 1, wherein
the cutout part (11) is formed in a periphery edge part of the plate.

3. The stacked plate heat exchanger according to claim 2, wherein
the plate on which the tab part (10) is formed is arranged at an intermediate layer excluding the uppermost layer and the lowermost layer in the plurality of inner plates (4).

4. The stacked plate heat exchanger according to claim 2, wherein
the tab part (10) is formed on at least one of the top plate (2) and the bottom plate (3).

## Patentansprüche

1. Stapelplattenwärmetauscher, der eine obere Platte (2), eine untere Platte (3) und eine Vielzahl von Innenplatten (4) umfasst, wobei
ein nach oben gebogener Laschenteil (10) auf zumindest einer der Platten ausgebildet ist,
ein Ausschnittsteil (11) in den Platten ausgebildet ist, die nicht jene Platte sind, auf der der Laschenteil (10) ausgebildet ist,
jede Platte mit dem Laschenteil (10) und dem Ausschnittsteil (11) in eingebautem Zustand aufeinander gestapelt und aneinander befestigt ist,
der Laschenteil (10) in einer rechteckigen Form mit einem Paar von Seitenflächen (12, 13) und einem Endteil (14) ausgebildet ist,
**dadurch gekennzeichnet, dass**:
der Ausschnittsteil (11) in einer rechteckigen Form mit einem Paar von Seitenflächen (16, 17) und einer Bodenfläche (18) ausgebildet ist,
beide Seitenflächen des Laschenteils (10) jeweils an beiden Seitenflächen des Ausschnittsteils (11) anliegen und
eine Oberfläche (19) des Laschenteils (10) in der Biegerichtung von der Bodenfläche (18) des Ausschnittsteils (11) getrennt ist.

2. Stapelplattenwärmetauscher nach Anspruch 1, wobei der Ausschnittsteil (11) in einem Umfangsrandteil der Platte ausgebildet ist.

3. Stapelplattenwärmetauscher nach Anspruch 2, wobei die Platte, auf der der Laschenteil (10) ausgebildet ist, in einer Zwischenschicht angeordnet ist, die die obere Schicht und die untere Schicht in der Vielzahl von Innenplatten (4) nicht einschließt.

4. Stapelplattenwärmetauscher nach Anspruch 2, wobei der Laschenteil (10) auf zumindest einer aus der obersten Platte (2) und der unteren Platte (3) ausgebildet ist.

## Revendications

1. Échangeur de chaleur à plaques empilées comprenant une plaque supérieure (2), une plaque inférieure (3) et une pluralité de plaques intérieures (4), dans lequel
une partie de languette pliée vers le haut (10) est formée sur au moins l'une des plaques,
une partie découpée (11) est formée dans les plaques autres que la plaque sur laquelle la partie de languette (10) est formée,
chaque plaque est empilée et fixée à une autre avec la partie de languette (10) et la partie découpée (11) dans un état monté,
la partie de languette (10) a une forme rectangulaire avec une paire de surfaces latérales (12, 13) et une partie d'extrémité (14),
**caractérisé en ce que**
la partie découpée (11) est formée en une forme rectangulaire avec une paire de surfaces latérales (16, 17) et une surface inférieure (18),
les deux surfaces latérales de la partie de languette (10) viennent en butée sur les deux surfaces latérales de la partie découpée (11), respectivement, et
une surface (19) de la partie de languette (10) dans la direction pliée est séparée de la surface inférieure (18) de la partie découpée (11).

2. Échangeur de chaleur à plaques empilées selon la revendication 1, dans lequel
la partie découpée (11) est formée dans une partie de bord périphérique de la plaque.

3. Échangeur de chaleur à plaques empilées selon la revendication 2, dans lequel
la plaque sur laquelle la partie de languette (10) est formée est agencée au niveau d'une couche intermédiaire excluant la couche la plus supérieure et la couche la plus inférieure dans la pluralité de plaques intérieures (4).

4. Échangeur de chaleur à plaques empilées selon la revendication 2, dans lequel
la partie de languette (10) est formée sur au moins une parmi la plaque supérieure (2) et la plaque inférieure (3).
